(19) Europäisches Patentamt
European Patent Office
Office européen des brevets

(11) **EP 3 096 283 A1**

(12) **EUROPEAN PATENT APPLICATION**
published in accordance with Art. 153(4) EPC

(43) Date of publication:
**23.11.2016 Bulletin 2016/47**

(51) Int Cl.:
*G06Q 50/06* (2012.01)    *G01R 11/57* (2006.01)
*G01R 21/00* (2006.01)    *H02J 3/00* (2006.01)
*H02J 13/00* (2006.01)

(21) Application number: **14870021.4**

(22) Date of filing: **03.07.2014**

(86) International application number:
**PCT/JP2014/067758**

(87) International publication number:
**WO 2015/087571 (18.06.2015 Gazette 2015/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **13.12.2013 JP 2013258641**

(71) Applicant: **Kabushiki Kaisha Toshiba**
**Minato-ku**
**Tokyo 105-8001 (JP)**

(72) Inventors:
• **KUBOTA Kazuto**
**Tokyo 105-8001 (JP)**

• **WADA Takahisa**
**Tokyo 105-8001 (JP)**
• **KATAYAMA Kyosuke**
**Tokyo 105-8001 (JP)**
• **MATSUE Kiyotaka**
**Tokyo 105-8001 (JP)**
• **NAGAIWA Akihiro**
**Tokyo 105-8001 (JP)**
• **SUYAMA Akihiro**
**Tokyo 105-8001 (JP)**

(74) Representative: **Hoffmann Eitle**
**Patent- und Rechtsanwälte PartmbB**
**Arabellastraße 30**
**81925 München (DE)**

(54) **BILL INFORMATION DETERMINATION DEVICE, BILL INFORMATION OUTPUT SYSTEM AND BILL INFORMATION DETERMINATION METHOD AND PROGRAM**

(57)    A price information determination device of an embodiment includes a determiner. The determiner determines electric-price-related information to be output for a consumer from a harmonic intensity of electric current or electric power in an electric power system and from an electric power consumption reduction target; wherein the determination is made based on a correlation among the electric-price-related information, the harmonic intensity of electric current or electric power in the electric power system, and electric power consumption in the electric power system.

FIG. 1

**Description**

[TECHNICAL FIELD]

The embodiments of the present invention relate to a price information determination device, a price information output system, a price information determination method and a program.

[BACKGROUND ART]

Demand response programs are becoming widespread for achieving optimization of electric power supply and demand balance by controlling electric power consumption on the demand side. Electric power consumption by consumers is controlled with a demand response program by outputting a demand response ("DR") signal to the consumer. The DR signal displays requests from the supplier side. Generally, DR signals are output containing electric power prices.

Even when DR signals are output, whether or not a consumer implements a reduction in electric power consumption due to electric rates depends upon the individual consumer, and the usage state of equipment that the consumer is operating.

Recently, techniques have been proposed for estimating the usage state of equipment operated by a consumer. However, these techniques do not relate to DR signals.

In general, when DR signal content does not reflect the deviations in judgment for individual consumers, and does not reflect the usage state of equipment operated by a consumer, there are cases where a consumer cannot be encouraged to actively consume a reasonable amount of electric power.

Control of excess demand can be achieved when the electric power price output by a DR signal is too high. However, there are cases where a necessary reduction in electric power cannot be achieved if the electric power price output by a DR signal is too low. In general, consumers stopping the use of equipment, or reducing the power output of equipment, easily allows for an electric power reduction as long as there is no large impairment to convenience. For cases where equipment having a controllable usage state is not operating, consumers tend to have difficulty reducing electric power use.

[Citation List]

[PATENT Literature]

[Patent Literature 1] JP Patent Application Publication No. 2000-292465

[Patent Literature 2] JP Patent Application Publication No. 2001-330630

[SUMMARY OF INTENTION]

[ISSUE TO BE SOLVED BY THE INVENTION]

The problem to be solved by the present invention is to provide a price information determination device, a price information output system, a price information determination method, and a program capable of determining an accurate electric rate depending upon the usage state and the like of equipment operated by a consumer.

[MEANS FOR SOLVING THE ISSUE]

A price information determination device of an embodiment includes a determiner. The determiner determines electric-price-related information to be output for a consumer from a harmonic intensity of electric current or electric power in an electric power system and from an electric power consumption reduction target; wherein the determination is made based on a correlation among the electric-price-related information, the harmonic intensity of electric current or electric power in the electric power system, and electric power consumption in the electric power system.

[BRIEF DESCRIPTION OF DRAWINGS]

FIG. 1 is a block diagram illustrating a configuration of a price information output system of an embodiment.

FIG. 2 is a block diagram illustrating a configuration of a personal computer 200.

FIG. 3 is a diagram illustrating an example of a hardware configuration for realizing a meter.

FIG. 4 is a block diagram illustrating functional block of a DSP.

FIG. 5 is a diagram illustrating an example of an electric power reduction request signal (amount of used electric power reduction per unit time).

FIG. 6 is a diagram illustrating a regression plane in a three dimensional coordinate system.

FIG. 7 is a block diagram illustrating a configuration of a price information output system 100a of Modification 1.

FIG. 8 is a block diagram illustrating a configuration of a price information output system 100b of Modification 2.

[DESCRIPTION OF EMBODIMENTS]

1. Price Information Output System Configuration

A price information determination device, a price information output system, a price information determination method, and a program relating to embodiments are explained below with reference to the drawings.

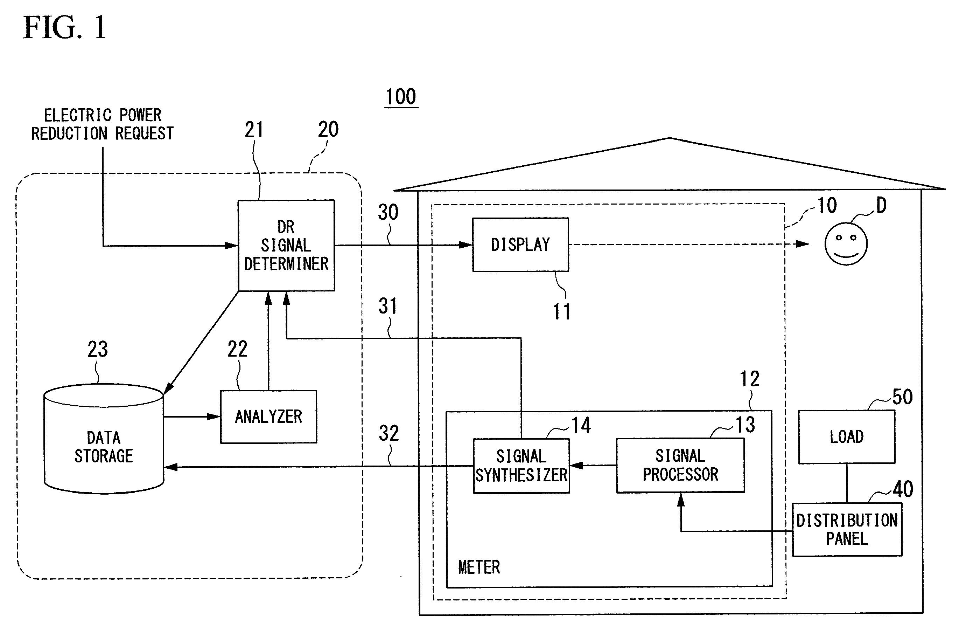

FIG. 1 is a block diagram illustrating a configuration of a price information output system of the present embodiment. The price information output system 100 includes consumer devices 10 disposed in consumer management areas such as consumer's house, office, factory, or the like, and a price information determination device 20 connected to the consumer device 10 through communication lines 30, 31, and 32. The price information determination device 20 is configured as a server computer managed by an electric power supply company.

An electric power system is connected to a load 50 via a meter 12 of the consumer device 10 and a distribution panel 40. The load 50 is, for example, a type of consumer equipment. In FIG. 1, a single load 50 is shown in order to simplify explanation. However, a plurality of the loads 50 may be connected to the distribution panel 40. There is no limitation placed on the number of the loads 50.

The consumer device 10 includes a display 11 and the meter 12.

The display 11 displays output of electric rate information relating to electric rates for a consumer D, based on output from a DR signal determiner 21 of the price information determination device 20. In addition to displaying in the display 11, electric price information output to the consumer D may be provided in an arbitrary manner, such as aural information by voice output, and printing using a printer device.

The meter 12 accumulates and performs statistical processing on information relating to electric power output of electric current flowing from electric systems managed by the consumer D to the distribution panel 40. The meter 12 includes a signal processor 13 and a signal synthesizer.

The signal processor 13 samples electric current i and voltage v of the electric power system. The sampling frequency is taken as s. For example, s is 2 kHz.

A first function of the signal processor 13 is product-sum computation processing. The signal processor 13 computes electric power consumption by performing product-sum operations on the electric current i and the voltage v of the electric power system. The signal processor 13 aggregates sampled electric current i and voltage v at intervals of 1 second, for example, and creates electric power consumption values as time sequence data for 1 second interval by performing product-sum computation processing.

A second function of the signal processor 13 is frequency analysis processing. The signal processor 13 measures the harmonic intensity contained in the electric current i of the electric power system by using Fast Fourier Transformation processing. The signal processor 13 may also measure the harmonic intensity contained in electric power of the electric power system by using Fast Fourier Transform processing. The signal processor 13 measures at just what intensity at different harmonics are output by investigating signal peaks based on which harmonics are output at what intensity levels. The signal processor 13 implements Fast Fourier Transform processing at the same time interval (for example, every 1 second) as with the product-sum computation processing described above, and generates a spectral density.

The signal processor 13 can implement the present embodiment by measuring an arbitrary number (1, 2, ..., n) of harmonics. For brevity in the explanation below, an example is provided and explained where the signal processor 13 extracts a third order harmonic component intensity and generates time sequence data at 1 second intervals, for example. If the frequency of the electric power system is 50 Hz, the third order harmonic component is a component having a frequency equal to three times the electric power system frequency, which is 150 Hz.

The signal processor 13 outputs values of electric power consumption computed at 1 second intervals, and harmonic intensities (third order frequency component) measured at 1 second intensities, to the signal synthesizer 14.

The signal synthesizer 14 performs statistical processing on the electric power consumption and the harmonic intensities output by the signal processor 13. Typical statistical processing performed by the signal synthesizer 14 is average value computation and median computation, but the content of the statistical processing performed by the signal synthesizer 14 is not limited.

The electric power consumption and the harmonic intensities that undergo statistical processing by the signal synthesizer 14 are output to the price information determination device 20 and stored in a data storage 23.

The price information determination device 20 includes the DR signal determiner 21, an analyzer 22, and the data storage 23.

The DR signal determiner 21 receives electric power reduction request signals from the outside, through a communication line, and sends received electric power reduction request signals to the date storage 23.

The data storage 23 is a storage device for storing various types of information including electric power consumption and harmonic intensities output from the consumer device 10, and electric power reduction request signals output by the DR signal determiner 21.

The analyzer 22 generates DR signal determination rule information used in determining electric price information, based on information stored in the data storage 23. The analyzer 22 outputs generated DR signal determination rule information to the DR signal determiner 21.

The DR signal determiner 21 determines electric rate information based on the electric power consumption and harmonic intensities sent by the signal synthesizer 14 of the consumer device 10, the electric power consumption reduction amount included in the electric power reduction request signal, and the DR signal determination rule information output by the analyzer 22, and outputs the electric rate information to the display 11 of the consumer device 10.

The electric rate information generated by the DR signal determiner 21 may be a unit price for electric power consumption of the electric power system, and may also be a total price for an amount of electric power used in the electric power system. The electric rate information generated by the DR signal determiner 21 is taken as a unit price for electric power used by the electric power system, and explained below.

The consumer D confirms the electric rate information output to the display 11, and operates an output state, or an on or off state, of the load 50. For example, among the loads 50, consumer electronic equipment that performs inverter control (for example, an air conditioner, a washing machine, a refrigerator, or the like) can in particular generate harmonics in the electric power system. For example, if the electric power supply frequency of the electric power system is 50 Hz, harmonics with odd multiples of the electric power supply frequency are likely to occur. The harmonic intensity changes according to the output state, and by the on state or off state, of the load 50.

2. Example Implementations of Various Configurations

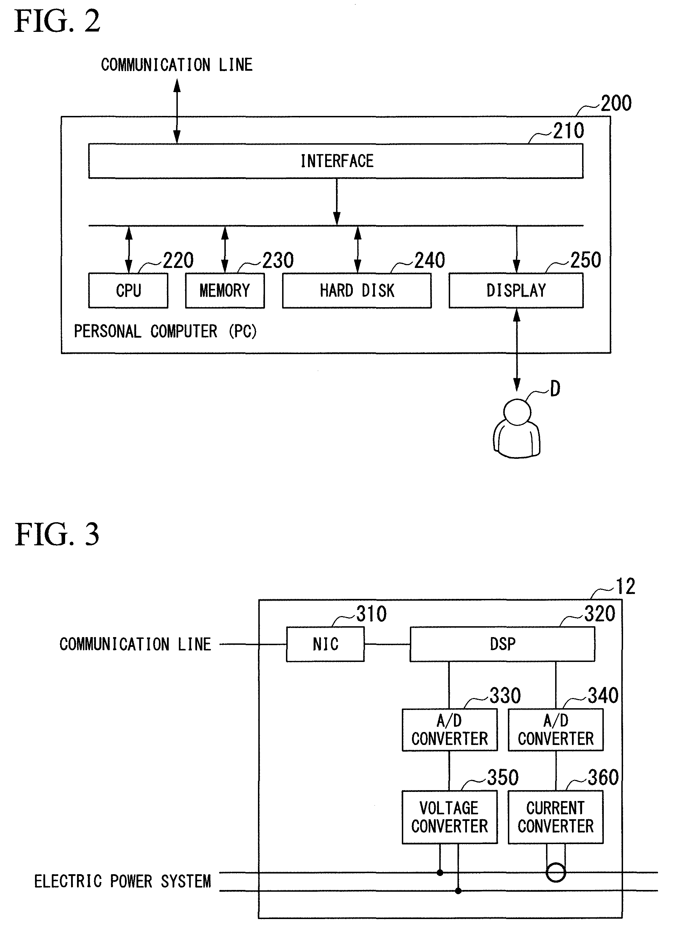

Among the configurations described above, the price information determination device 20, and the display 11 of the consumer device 10 can be realized by a personal computer 200 illustrated in FIG. 2, and by software run on the personal computer 200.

FIG. 2 is a block diagram illustrating a configuration of the personal computer 200. The personal computer 200 includes an interface 210 for communicating with the outside through a communication line, a CPU (Central Processing Unit) 220, a memory 230, a hard disk 240, and a display 250, all connected together through a bus.

The CPU 220 implements functions of the DR signal determiner 21 and the analyzer 22. The memory 230 or the hard disk 240 implements the functions of the data storage 23, and the display 250 implements the functions of the display 11.

A program configuring the above described software is stored on the hard disk 240, and then run in order after being deployed to the memory 230.

FIG. 3 is a diagram illustrating an example of a hardware configuration for realizing the meter 12. In the example of FIG. 3, the meter 12 includes an NIC (Network Interface Card) 310, DSP (Digital Signal Processor) 320, an A/D (Analog to Digital) converters 330 and 340, a voltage converter 350, and an electric current converter 360. A current system supplies electric power through two alternating current lines. The voltage converter 350, the electric current converter 360, the A/D converter 330, and the A/D converter 340 implement functions of the signal processor 13, and the DSP 320 implements functions of the signal synthesizer 14.

Voltage from the electric power system is processed by passing through the voltage converter 350. Current from the electric power system is input to the A/D (Analog to Digital) converters 330 and 340 through the electric current converter 360, via a CT (Current Transformer), and processed by the DSP 320.

Electric power consumption and harmonic intensities processed by the system described above in the DSP 320 are then sent to the DR signal determiner 21 and the data storage 23 of the price information determination device 20, via the NIC 310 and the communication line.

The data storage 23 stores the received electric power consumption and harmonic intensities. In conjunction with this, the DR signal determiner 21 sends electric rate information (unit price of electric power consumption of the electric power system) output to the display to the data storage 23, and the data storage 23 stores the received electric rate information.

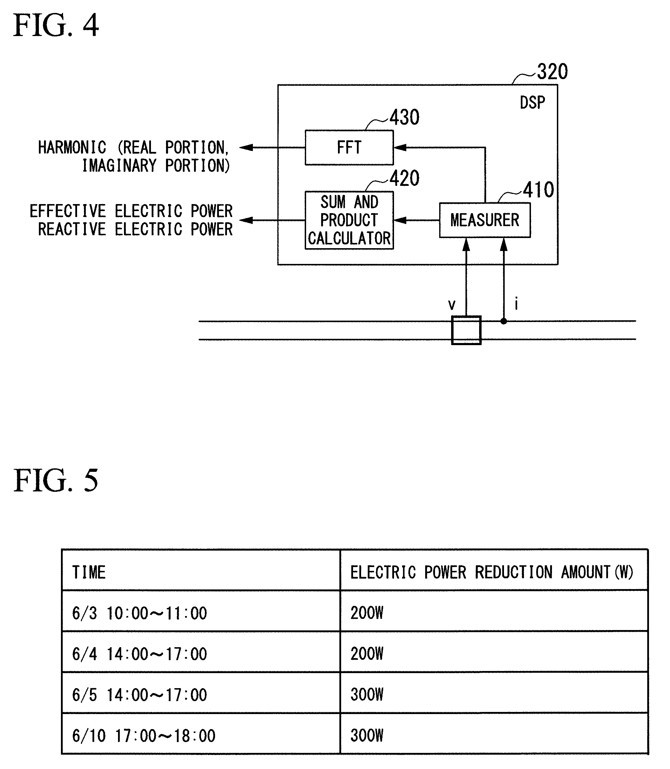

FIG. 4 is a block diagram illustrating a functional block of the DSP 320. The functional block of the DSP includes a measurer 410, a sum and product calculator 420, and an FFT (Fast Fourier Transformer) 430. The measurer 410 accumulates values of the electric current i and the voltage v sampled and output at a sampling frequency of 2 KHz, for example, by the A/D converters 330 and 340. The measurer 410 outputs the accumulated values to the sum and product calculator 420 and to the FFT 430. The sum and product calculator 420 computes electric power consumption by performing product-sum computations on the electric currents i and the voltages v. The FFT 430 measures harmonic intensities included in the electric current i of the electric power system by performing Fast Fourier Transform processing.

3. Method for Determining Price Information

The price information output system 100 determines new electric rate information from: a current harmonic intensity, in other words from the harmonic intensity output by the meter 12 at a point where the electric rate is to be determined; and from a target value for an amount to reduce electric power consumption, in other words from an electric power consumption reduction amount included in the electric power reduction request signal. The determination is made based on correlated information for prior electric rate information, prior harmonic intensities, and prior electric power reduction amounts.

The harmonic intensities detected by the price information output system 100 differ according to the type and operation state of the load 50 in the electric power system used by the consumer D. For example, for cases where the load 50 is an air conditioner used at high output, the harmonic intensities in the electric power system become larger.

The price information output system 100 determines appropriate electric rate information reflecting the harmonic intensities. As a result, the price information output system 100 determines electric rate information that differs according to the type and operation condition of the load in the electric power system used by the consumer D.

Generation of DR signal determination rule information by the analyzer 22 is explained. The analyzer 22 generates DR signal determination rule information used in determining electric price information based on information stored in the data storage 23.

The analyzer 22 generates DR signal determination rule information based on a time sequence (15 minute intervals) of electric rate information (unit price of electric power used by the electric power system), a time sequence of electric power consumption (1 second intervals), and a time sequence of harmonic intensities (1 second intervals) from among the information stored in the data storage 23.

FIG. 5 is a diagram illustrating an example of an electric power reduction request signal (amount of used electric power reduction per unit time) received by the DR signal determiner 21 at each time (date and time) shown, and stored in the storage 23.

The analyzer 22 extracts an electric power consumption reduction request start time $T_{st}$ from information in each electric power reduction request signal described above. In an example of an initial electric power consumption request signal, the electric power consumption reduction request start time $T_{st}$ is 3 June (6/3) at 10 AM.

An electric power consumption value at the electric power consumption reduction request start time $T_{st}$ is taken as $W_c$, an electric power consumption value at a time before the electric power consumption reduction request start time $T_{st}$ by a predefined amount of time $T_{back}$ (for example, 5 minutes) is taken as $W_b$, and an electric power consumption value at a time after the electric power consumption reduction request start time $T_{st}$ by a predefined amount of time $T_{forward}$ (for example, 5 minutes) is taken as $W_f$. Further, a harmonic (third order harmonic component) intensity value at the electric power consumption reduction request start time $T_{st}$ is taken as $H_c$, a harmonic (third order harmonic component) intensity value at a time before the electric power consumption reduction request start time $T_{st}$ by the predefined amount of time $T_{back}$ is taken as $H_b$, and a harmonic (third order harmonic component) intensity value at the predefined amount of time $T_{forward}$ after the electric power consumption reduction request start time $T_{st}$ is taken as $H_f$.

An electric power consumption reduction amount $W_d$ around the electric power consumption reduction request start time $T_{st}$ is expressed by $W_d = W_f - W_b$.

Electric power information (unit price for electric power used by the electric power system) displayed in the display 11 at a time before the electric power consumption reduction request start time $T_{st}$ by the predefined amount of time $T_{back}$ is taken as $P_b$, and electric power information displayed in the display 11 at the predefined amount of time $T_{forward}$ after the electric power consumption reduction request start time $T_{st}$ is taken as $P_f$.

A rate difference $P_{rd}$ for electric rate information (unit price for electric power used by the electric power system) around the electric power consumption reduction request start time $T_{st}$ is expressed by $P_{rd} = P_f - P_b$.

The analyzer 22 extracts the electric power consumption reduction request start time $T_{st}$ for all electric power reduction request signals (electric power consumption reduction amounts at each time) stored in the data storage 23, and derives the electric power consumption $W_c$, the electric power consumption $W_b$, the electric power consumption $W_f$, the harmonic intensity $H_c$, the harmonic intensity $H_b$, the harmonic intensity $H_f$, the electric power consumption reduction amount $W_d$, the electric rate information $P_b$, the electric rate information $P_f$, and the rate difference $P_{rd}$.

The analyzer 22 computes the electric power consumption reduction amount $W_d$ for all electric power reduction request signals (electric power consumption reduction amounts at each time) stored in the data storage 23 by virtually computing a regression plane using the electric power consumption $W_c$, the harmonic (third order harmonic component) intensity $H_b$, and the electric rate information rate difference $P_{rd}$.

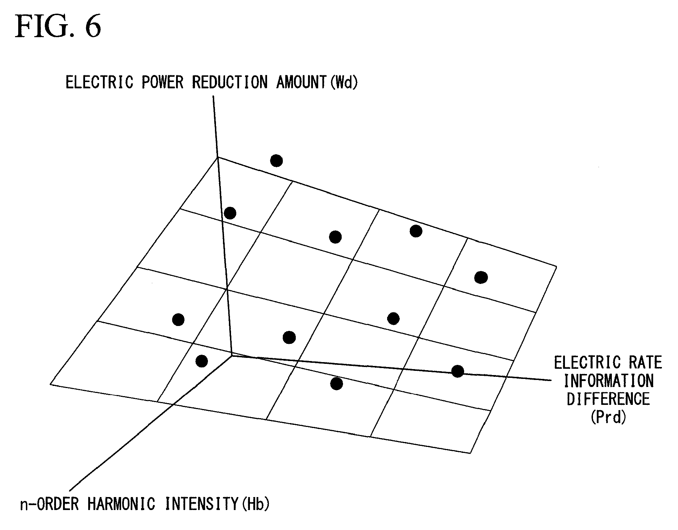

FIG. 6 is a diagram illustrating the regression plane described above in in a three dimensional coordinate system of electric power consumption reduction amount $W_d$, n-order harmonic component (for example, third order harmonic component) intensity $H_b$, and electric rate information rate difference $P_{rd}$. The regression plane applies to a plane of plotted points, where the electric power consumption reduction amount $W_d$, the harmonic (third order harmonic component) intensity $H_b$, and the electric rate information rate difference $P_{rd}$ are plotted in a three dimensional space.

Regarding the regression plane, the electric rate information rate difference Prd is expressed by the following equation: $P_{rd} = \alpha \times W_d + \beta \times W_c + \gamma \times H_b + \delta$. Variables $\alpha$, $\beta$, $\gamma$, and $\delta$ are regression coefficients uniquely defined. The regression coefficients may be determined arbitrarily by a regression analysis method. For example, for n points $(x_i, y_i)$, where i = 1, ..., n, on the surface of the same plane, when regressing $y_i$ and $x_i$, a regression line is expressed by the equation $y = \alpha x + \beta$. In this case the regression coefficients $\alpha$ and $\beta$ are found by EQ. 1 and EQ. 2, for example.

$S_{xy}$ in EQ. 1 expresses covariances of $x_i$ and $y_i$. Sxy is found by using EQ. 3. $S_x$ in EQ. 1 expresses scattering of $x_i$. $S_x$ is found by using EQ. 4. In EQ. 2, $x_m$ expresses the average of $x_i$. EQ. 5 is used to find $x_m$. In EQ. 2, $y_m$ expresses the average of $y_i$. EQ. 6 is used to find $y_m$.

Note that the methods described in "Regression Analysis and Its Applications" (T.H. Wonnacott, 1998) may also be used, for example, as ways of finding regression coefficients for cases where the number off regression coefficients is three or greater.

$$\beta = \frac{S_{xy}}{S_x} \qquad ...(\text{equation } 1)$$

$$\alpha = (y_m - \beta x_m) \qquad ...(\text{equation } 2)$$

$$S_{xy} = \left(\frac{1}{n}\right)\sum_{i=1}^{n}(x_i - x_m)(y_i - y_m) \qquad ...(\text{equation } 3)$$

$$S_x = \left(\frac{1}{n}\right)\sum_{i=1}^{n}(x_i - x_m)^2 \qquad ...(\text{equation } 4)$$

$$x_m = \left(\frac{1}{n}\right)\sum_{i=1}^{n}x_i \qquad ...(\text{equation } 5)$$

$$y_m = \left(\frac{1}{n}\right)\sum_{i=1}^{n}y_i \qquad ...(\text{equation } 6)$$

That is, the equations described above may be used to fine that in order to reduce the electric power consumption by Wd (for example, 200 W) based on an n-order harmonic component(for example, third order harmonic component), the electric rate information may be changed by the rate difference Prd. This equation becomes DR signal determination rule information generated by the analyzer 22.

A method of determining electric rate information determined by the DR signal determiner 21 is explained. The DRO signal determiner 21 determines electric rate information by referring to the DR signal determination rule information generated by the analyzer 22.

The DR signal determiner 21 investigates currently provided electric power reduction request signals stored in the data storage 23, and judges whether or not there is an electric power reduction request signal for 30 minutes after the current time.

If there is no electric power reduction request signal for 30 minutes after the current time, the DR signal determiner outputs electric rate information based on a default rate table, without implementing the rate information determination method in the present embodiment.

On the other hand, when an electric power reduction request signal for 30 minutes after the current time is present, the DR signal determiner 21 pulls out the electric power consumption reduction amount $W_d$ from the electric power reduction request signal, and further, acquires the harmonic (third order harmonic component) intensity $H_b$ from the meter 12. The DR signal determiner 21 inputs the electric power consumption reduction amount $W_d$ and the harmonic (third order harmonic component) intensity $H_b$ into the DR signal determination rule information generated by the analyzer 22, and determines the electric rate information $P_{rd}$.

The electric rate information $P_{rd}$ can be output to the consumer D from the electric power reduction request start time $T_{st}$ as a fluctuating electric rate difference. Further, the electric rate information $P_b$ at a time prior to the electric power reduction request start time $T_{st}$ by the predefined time $T_{back}$ is added, and the result can be output to the consumer D as new electric rate information from the electric power reduction request start time $T_{st}$.

According to the present embodiment, by determining electric rate information based on harmonic information, accurate electric rate information can be found that reflects the state of operating equipment.

In general, even if identical electric power prices are set for identical electric power consumption volumes when implementing a demand response program, identical electric power reduction effects are not always obtained for the consumer D and a different consumer D'. This is because even if identical electric power amounts are used, it is possible that the equipment being utilized is different. To what level electric power use is able to be reduced differs according to the type of equipment in use. In general, air conditioner equipment and heating equipment are good pieces of equipment for reducing electric power consumption by consumers.

By observing electric power system harmonics, it is possible to implement electric rate information determination that reflects, for example, whether or not different types of equipment (for example, an air conditioner) are in use, and the intensity of their use. That is, by modelling electric power reductions that reflect harmonic information when implementing a demand response program, it becomes possible to generate very realistic electric rate information (DR signal).

By making a model that fuses harmonic information that reflects the operation state of load equipment (for example, home electronics products), electric power consumption, and electric rate information, it becomes possible to generate very realistic rate information (DR signal). This type of model (DR signal determination rule information) may be created based on data acquired from individual consumers, and may also be created by using data totaled from multiple consumers. If a model is created based on data acquired from individual consumers, rate determination can be performed corresponding to consumption trend characteristics of the individual consumers (for example, how much does electric power consumption change due to changes in electric power price). For example, even if an air conditioner and a washing machine consume the same 10 W, their harmonics will differ.

At a state where there is no accumulated data acquired for a managed area of the consumer D, a model (DR signal determination rule information) may be derived using data acquired from a management area of another consumer D'.

As time passes and the amount of acquired data for various consumers increases, the statistical data accuracy will increase. However, if there are changes to the configuration of load equipment, very accurate electric rate information can be determined corresponding to the state.

4. Modification 1

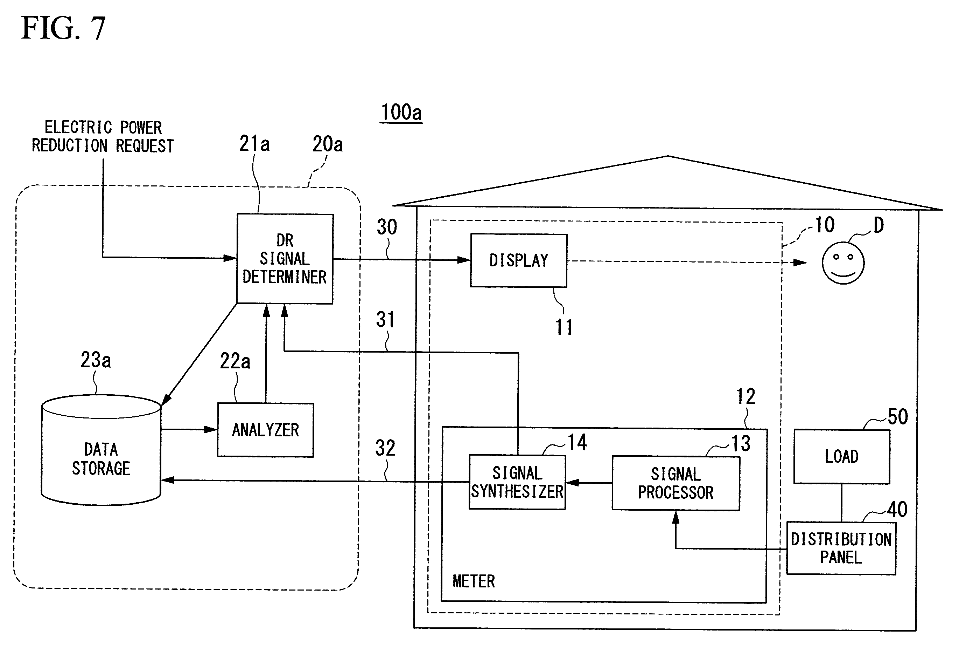

FIG.7 is a block diagram illustrating a configuration of a price information output system 100a of Modification 1. The price information output system 100a of Modification 1 differs from the price information output system 100 of the embodiments in that a rate information determination device 20a is provided as a substitute for the price information determination device 20. The price information determination device 20a differs from the price information determination device 20 in that a DR signal determiner 21 a is provided as a substitute for the DR signal determiner 21, in that an analyzer 22a is provided as a substitute for the analyzer 22, and in that a data storage 23a is provided as a substitute for the data storage 23. With the price information output system 100a of Modification 1, the DR signal determiner 21a, the analyzer 22a, and the data storage 23a are implemented by a program on a cloud computer.

The cloud computer has advantages in coordination, IT automation, and client recognition. Applications optimized for an end user can be provided by a cloud computer that recognizes a client.

The price information output system 100a makes it possible to very effectively achieve functions such as each type of DR signal processing by using a cloud computer connected to the consumer device 10 set within a consumer management area.

5. Modification 2

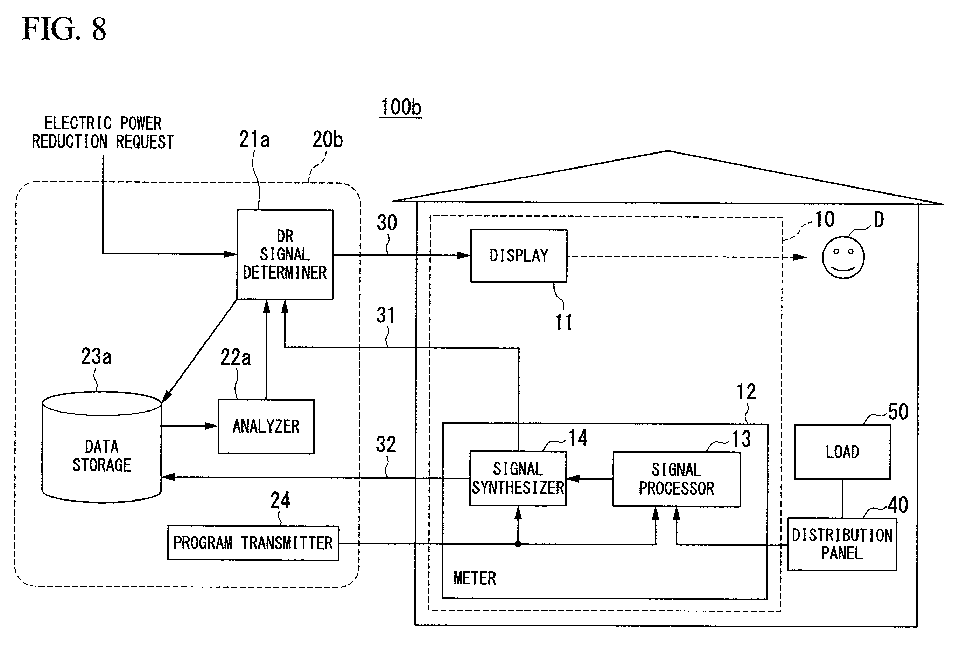

FIG. 8 is a block diagram illustrating a configuration of a price information output system 100b of Modification 2. The price information output system 100b of Modification 2 differs from the price information output system 100a of Modification 1 in that a price information determination device 20b is provided as a substitute for the price information determination device 20a. The price information determination device 20b differs from the price information determination device 20a in that a program transmitter 24 is provided. The program transmitter 24 achieves a function of sending programs such as an Operating System (OS) to the DSP 320 of the meter 12 in the consumer device 10.

Provided that the existence of the program transmitter 24 makes it possible to substitute the DSP 320 program with an instruction from the price information determination device 20b, for cases where a new analysis algorithm is implemented, it becomes possible to implement a program corresponding to the new analysis algorithm in the DSP 320 without wastefully exchanging hardware such as the meter 12 in the consumer device 10.

A program for achieving functions in the embodiments and the embodiment Modifications described above may be recorded on a computer readable recording medium. The program recorded on the recording medium may be read into a computer system, and control operations may be performed by running the program. Note that the term "computer system" includes Operating Systems (OSes) and hardware such as peripheral equipment. Further, the term "computer readable recording medium" means a media such as flexible disks, optical magnetic disks, Read Only Memories (ROMs), and the like, and storage devices such as hard disks installed within a computer system.

In addition, the term "computer readable recording medium" includes media on which fixed time programs are stored, such as volatile memory within a computer system that becomes a server or a client when sending a program through a communication line such as a network like the Internet, a phone line, or the like.

Further, the program described above may also be sent from a computer system in which the program is stored on a recording medium or the like, through a transmission medium or by a transmission wave within a transmission medium. The term "transmission medium" that transmits the program means a medium having a function to transmit information, such as a network (communication net) like the Internet, or a communication line (communication wire) like a telephone like. Further, the program may also realize in part the functions described above. In addition, the functions described above can also be achieved in combination with a program already recorded in a computer system, known as a difference file (difference program).

In each of the embodiments described above, the DSP 320 is explained as executing product-sum computations or Fast Fourier Transformation processing. However, signal processing executed by the DSP 320 is not limited, and arbitrary processes may also be added.

As described above, provided that it is possible to rewrite a program in the DSP 320 through an instruction from the price information determination device 20, the analysis precision of each price information output system can be raised by implementing a new analysis algorithm.

According to the price information determination device, the price information output system, the price information determination method, or the program of at least one embodiment described above, it becomes possible to determine a very accurate electric rate corresponding to the usage state of equipment operated by a consumer. This is achieved by determining an electric rate based on harmonics in an electric power system.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A price information determination device comprising:

   a determiner that determines electric-price-related information to be output for a consumer from a harmonic intensity of electric current or electric power in an electric power system and from an electric power consumption reduction target; wherein the determination is made based on a correlation among the electric-price-related information, the harmonic intensity of electric current or electric power in the electric power system, and electric power consumption in the electric power system.

**2.** The price information determination device according to claim 1, wherein the harmonic intensity is measured by applying Fast Fourier Transformation to the electric current or the electric power of the electric power system.

**3.** The price information determination device according to claim 1 or claim 2, wherein the determiner determines the electric price-related information based on regression analysis using the correlation.

**4.** The price information determination device according to any one of claims 1 to 3, wherein the electric price-related information includes a unit price for electric power consumption of the electric power system.

**5.** The price information determination device according to any one of claims 1 to 3, wherein:

the electric price-related information includes rates for an electric power amount used by the electric power system; and
the determiner computes the electric power amount.

**6.** The price information determination device according to any one of claims 1 to 5, further comprising an analyzer that generates the correlation, and supplies the generated correlation to the determiner.

**7.** The price information determination device according to any one of claims 1 to 6, further comprising a storage that stores the electric price-related information, the harmonic intensity, the electric power consumption, and the electric power consumption reduction target.

**8.** The price information determination device according to any one of claims 1 to 7, wherein the correlation is an interrelation among the electric price-related information, the harmonic intensity of electric current or electric power in the electric power system to be output before the electric price-related information is output for the consumer, and electric power consumption reduction amounts before and after the electric rate information is output for the consumer.

**9.** A price information output system comprising:

the price information determination device according to any one of claims 1 to 8;
a measurer that measures the electric current or electric power harmonic intensity in an electric power system managed by the consumer; and
an output that outputs the electric rate information for the consumer.

**10.** The price information output system according to claim 9, wherein:

the measurer and the output are incorporated into a consumer device set within a management area of the consumer; and
the price information determination device is connected to the consumer device through a communication line.

**11.** The price information output system according to claim 10, further comprising a transmitter that transmits a program to the measurer.

**12.** A price information determination method comprising:

determining electric-price-related information to be output for a consumer from a harmonic intensity of electric current or electric power in an electric power system and from an electric power consumption reduction target; wherein the determination is made based on a correlation among the electric-price-related information, the harmonic intensity of electric current or electric power in the electric power system, and electric power consumption in the electric power system.

**13.** A recording medium on which a program is stored for having a computer to implement a price information determination method comprising:

determining electric-price-related information to be output for a consumer from a harmonic intensity of electric current or electric power in an electric power system and from an electric power consumption reduction target; wherein the determination is made based on a correlation among the electric-price-related information, the harmonic intensity of electric current or electric power in the electric power system, and electric power consumption in the electric power system.

# FIG. 1

# FIG. 2

COMMUNICATION LINE

200

210

INTERFACE

220
CPU

230
MEMORY

240
HARD DISK

250
DISPLAY

PERSONAL COMPUTER (PC)

D

# FIG. 3

12

COMMUNICATION LINE

310
NIC

320
DSP

330
A/D CONVERTER

340
A/D CONVERTER

350
VOLTAGE CONVERTER

360
CURRENT CONVERTER

ELECTRIC POWER SYSTEM

# FIG. 4

HARMONIC (REAL PORTION, IMAGINARY PORTION)

EFFECTIVE ELECTRIC POWER
REACTIVE ELECTRIC POWER

~320
DSP

~430
FFT

~420
SUM AND PRODUCT CALCULATOR

~410
MEASURER

v    i

# FIG. 5

| TIME | ELECTRIC POWER REDUCTION AMOUNT (W) |
|------|--------------------------------------|
| 6/3 10:00~11:00 | 200W |
| 6/4 14:00~17:00 | 200W |
| 6/5 14:00~17:00 | 300W |
| 6/10 17:00~18:00 | 300W |

# FIG. 6

ELECTRIC POWER REDUCTION AMOUNT(Wd)

ELECTRIC RATE
INFORMATION
DIFFERENCE
(Prd)

n-ORDER HARMONIC INTENSITY(Hb)

# FIG. 7

ELECTRIC POWER REDUCTION REQUEST

100a

DR SIGNAL DETERMINER — 21a / 20a

DISPLAY — 11

30

31

DATA STORAGE — 23a

ANALYZER — 22a

32

SIGNAL SYNTHESIZER — 14

SIGNAL PROCESSOR — 13

METER — 12

LOAD — 50

DISTRIBUTION PANEL — 40

10 / D

EP 3 096 283 A1

## FIG. 8

ELECTRIC POWER
REDUCTION REQUEST

100b

21a  20b

DR SIGNAL DETERMINER

30 → DISPLAY → 11 → 10 → D

31

23a → DATA STORAGE

22a → ANALYZER

32

24 → PROGRAM TRANSMITTER

12

14 → SIGNAL SYNTHESIZER

13 → SIGNAL PROCESSOR

50 → LOAD

40 → DISTRIBUTION PANEL

METER

EP 3 096 283 A1

<table>
<tr><td colspan="2" align="center">**INTERNATIONAL SEARCH REPORT**</td><td>International application No.<br>PCT/JP2014/067758</td></tr>
</table>

**A. CLASSIFICATION OF SUBJECT MATTER**
*G06Q50/06*(2012.01)i, *G01R11/57*(2006.01)i, *G01R21/00*(2006.01)i, *H02J3/00*(2006.01)i, *H02J13/00*(2006.01)i

According to International Patent Classification (IPC) or to both national classification and IPC

**B. FIELDS SEARCHED**

Minimum documentation searched (classification system followed by classification symbols)
G06Q50/06, G01R11/57, G01R21/00, H02J3/00, H02J13/00

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 5283803 B1 (The Chugoku Electric Power Co., Inc.),<br>07 June 2013 (07.06.2013),<br>entire text; all drawings<br>& WO 2014/076785 A1 | 1–13 |
| A | JP 2005-107901 A (Hitachi, Ltd.),<br>21 April 2005 (21.04.2005),<br>entire text; all drawings<br>(Family: none) | 1–13 |
| A | WO 2011/142131 A1 (Panasonic Corp.),<br>17 November 2011 (17.11.2011),<br>entire text; all drawings<br>& US 2013/0060352 A1     & EP 2570977 A1<br>& CN 102893303 A       & KR 10-2013-0108507 A | 1–13 |

☐ Further documents are listed in the continuation of Box C.     ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>12 August, 2014 (12.08.14) | Date of mailing of the international search report<br>19 August, 2014 (19.08.14) |
|---|---|
| Name and mailing address of the ISA/<br>Japanese Patent Office | Authorized officer |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000292465 A

- JP 2001330630 A

**Non-patent literature cited in the description**

- **T.H. WONNACOTT.** *Regression Analysis and Its Applications,* 1998